# DEMANDE DE BREVET EUROPEEN

(11) **EP 3 242 536 A1**
(43) Date de publication de la demande: **08.11.2017**
(21) Numéro de dépôt: 16305511.4
(22) Date de dépôt: 03.05.2016
(51) Int. Cl.: H05K 1/16

(54) **PANNEAU COMPRENANT UN COMPOSANT ELECTRONIQUE**

(71) Demandeur: Schott VTF (Societe Par Actions Simplifiee), 57870 Troisfontaines (FR)
(72) Inventeur: DE ZORZI, Serge, 57870 Walscheid (FR); KOLHEB, Benoît, 57444 Reding (FR); LONDICHE, Bénédicte, 57400 Sarrebourg (FR)
(74) Mandataire: Kessler, Marc

(57) **Abrégé**

La présente invention se rapporte à un panneau (1) comprenant un support (2) comprenant au moins une surface (7 ou 8) recouverte d'une couche conductrice (3), structurée pour délimiter au moins deux pistes (10, 11) formant des conducteurs de tension en contact électrique avec un ou plusieurs composants électroniques (4) et des moyens (5) d'alimentation en électricité dudit ou desdits composants électroniques (4), ledit panneau (1) comprenant des moyens d'isolation électrique comprenant une ou plusieurs lignes de discontinuité (12) dans l'épaisseur d'une ou desdites au moins deux pistes conductrices (10 et 11) et/ou une couche isolante (6) recouvrant ledit support (2) et ladite couche conductrice (3). L'invention porte également sur une méthode d'obtention d'un tel panneau (1).

## Description

### Objet de l'invention

La présente invention a trait à un panneau, de préférence en verre, comprenant un ou plusieurs composants électroniques, du type Composants Montés en Surface (CMS), en particulier une ou plusieurs Diode Electro Luminescentes (DEL ou LED), et porte également sur un procédé d'obtention d'un tel panneau.

### Etat de la technique

Les panneaux en matière plastique ou en verre sont largement utilisés dans de nombreux domaines, comme par exemple le vitrage, le mobilier urbain, l'aménagement intérieur d'une maison ou d'un appartement, l'ameublement ou les équipements électroménagers.

En particulier, ces panneaux sont largement utilisés comme cloisons, éléments de sol, marches d'escalier, mais également, pour ce qui concerne les panneaux en verre, comme éléments d'appareils électroménagers, par exemple de cuisinières ou de four de cuisson, comme tablettes de réfrigérateurs, ou bien encore comme portes ou étagères de meuble.

Sont également bien connus, des panneaux lumineux, généralement en verre, comprenant, ou intégrant, un éclairage, permettant d'illuminer les objets disposés sur de tels panneaux ou disposés dans les dispositifs comprenant de tels panneaux.

Généralement, les panneaux lumineux comprennent un ou plusieurs dispositifs lumineux, éventuellement avec leur alimentation électrique, une batterie par exemple, posés ou fixés sur une des surfaces des panneaux. Toutefois, ces panneaux lumineux sont bien souvent disgracieux et une fois les panneaux lumineux encombrés d'objets, l'efficacité des dispositifs lumineux est bien souvent réduite.

Pour remédier à cela, il a alors été proposé des panneaux lumineux dont le ou les dispositifs lumineux sont disposés, non plus sur la surface des panneaux, mais sur un ou plusieurs bords des panneaux.

Ainsi, pour des appareils électroménagers, en particulier des réfrigérateurs, il a été proposé de disposer les dispositifs lumineux dans un cadre, ou garniture, venant engager les bords d'un panneau support en verre.

Par exemple, le document US7434951 décrit une tablette comprenant un panneau en verre dont les bords engagent une garniture permettant la fixation de la tablette à l'intérieur d'un réfrigérateur, une garniture qui comprend un dispositif lumineux sous la forme d'un tube lumineux et des connecteurs électriques pour alimenter le dispositif lumineux. Toutefois, cette solution présente l'inconvénient d'être complexe à produire et encombrante du fait de la présence de la garniture. Par ailleurs, cette solution n'est pas d'un usage universel car l'intégration d'un tel panneau ou tablette dans un dispositif ou système, comme un meuble ou un équipement électroménager nécessite l'emploi d'un rack spécifique recevant la tablette.

Il existe également des panneaux lumineux moins encombrantes.

Par exemple, le document EP0900971 décrit un panneau lumineux comprenant un support en verre comprenant des pistes conductrices, faites d'une couche conductrice, sur lesquelles sont disposées des LEDs, les pistes entant réalisées à l'aide d'un masque, reprenant le motif des pistes à imprimer sur le support, lors de l'application de la couche conductrice.

Le document EP1450416 décrit un substrat de support transparent, pouvant être du verre, comprenant une couche conductrice transparente, déposée par dépôt chimique en phase vapeur (CVD) ou dépôt physique en phase vapeur (PVD), à base d'un métal ou oxyde de métal conducteur, la couche conductrice étant ensuite séparée, structurée, par découpe laser en au moins deux pistes distinctes conductrices, puis des diodes sont appliquées sur la couche conductrice à l'aide d'une pâte de soudure.

Ce type de panneaux est utilisé comme dispositif d'affichage, comme par exemple un écran vidéo, comme décrit dans le document DE102008009775.

Toutefois, les panneaux lumineux à pistes conductrices ou pistes conductrices, décrits ci-dessus, présentent l'inconvénient, lors de leur usage, de ne pas permettre de recevoir sur leur surface des objets ou des éléments métalliques ou des conducteurs, comme de l'eau ou de l'humidité, en garantissant le maintien de leur fonction d'éclairage. De façon plus générale, de tels panneaux, comprenant des composants électroniques, ne permettent pas de garantir le fonctionnement de ces composants lorsque les panneaux reçoivent sur leur surface un élément conducteur, par exemple de l'humidité, ou un objet métallique.

### Buts de l'invention

La présente invention vise à fournir un panneau comprenant sur l'une de ces surfaces un ou plusieurs composants électroniques et une méthode de fabrication d'un tel panneau, qui ne présentent pas les inconvénients de l'état de la technique.

La présente invention vise à fournir une alternative aux solutions de l'état de la technique existantes.

La présente invention vise également à fournir un panneau comprenant sur l'une de ces surfaces un ou plusieurs composants électroniques, qui soient d'un usage universel dans de nombreux domaines, et permettant la réalisation de la fonction du ou des composants électroniques en toutes circonstances.

### Résumé de l'invention

La présente invention porte sur un panneau comprenant un support comprenant au moins une surface recouverte d'une couche conductrice, structurée pour délimiter au moins deux pistes formant des conducteurs de tension en contact électrique avec un ou plusieurs composants électroniques et des moyens d'alimentation en électricité du ou des composants électroniques, le panneau comprenant des moyens d'isolation électrique comprenant une ou plusieurs lignes de discontinuité dans l'épaisseur d'une ou plusieurs des au moins deux pistes conductrices et/ou une couche isolante recouvrant le support et la couche conductrice.

Selon des modes préférés de l'invention, le panneau selon l'invention comprend au moins une, ou une combinaison quelconque appropriée, des caractéristiques suivantes :
- les au moins deux pistes sont en contact électrique avec un ou plusieurs composants électroniques et des moyens d'alimentation en électricité par l'intermédiaire d'une pâte conductrice,
- la pâte conductrice est appliquée sur la couche conductrice ou sur la couche isolante si cette dernière est présente,
- la couche isolante ne recouvre pas le ou les composants électroniques, ni la pâte conductrice si cette dernière est présente,
- le support est fait de verre transparent, la couche conductrice est transparente et comprend de l'oxyde d'étain, la couche isolante est transparente est comprend un ou plusieurs oxydes métalliques non conducteurs et le ou les composants électroniques sont des Diodes Electro Luminescentes,
- les moyens d'alimentation en électricité du ou des composants électroniques comprennent des connecteurs comprenant chacun une pièce conductrice s'engageant dans, et s'étendant au-delà, d'un trou débouchant pratiqué dans le support,
- le panneau comprend en outre au moins une couche supplémentaire déposée sur la couche conductrice ou la couche isolante et/ou le ou les composants électroniques, la au moins une couche supplémentaire ayant des propriétés hydrophobes et/ou oléophobes, hydrophiles et/ou oléophiles, photocatalytiques, antisalissures réfléchissant le rayonnement thermique ou infra rouge et/ou antireflets,
- le panneau est une tablette de meubles, d'armoires, de commodes, de vitrines ou de réfrigérateurs ou un vitrage d'automobile.

La présente invention porte aussi sur une méthode de fabrication d'un panneau comprenant un ou plusieurs composants électroniques et des moyens d'alimentation en électricité dudit ou desdits composants électroniques, en particulier le panneau selon l'invention, la méthode comprenant les étapes de prendre un support comprenant au moins une surface et la recouvrir d'une couche conductrice, ou de prendre un support déjà recouvert d'une couche conductrice sur au moins une surface, et comprenant éventuellement des moyens d'alimentation en électricité du ou des composants électroniques, de réaliser sur le support des moyens d'alimentation en électricité si le support n'en comprend pas déjà, de structurer la couche conductrice pour former au moins deux pistes formant des conducteurs de tension, de mettre en contact électrique un ou des composants électroniques sur la couche conductrice, de manière à être en contact électrique avec les au moins deux pistes, de réaliser des moyens d'isolation du panneau, en réalisant une ou plusieurs lignes de discontinuité dans l'épaisseur d'une ou plusieurs des au moins deux pistes conductrices et/ou en déposant une couche isolante sur la couche conductrice et le support.

Selon des modes préférés de l'invention, la méthode selon l'invention comprend au moins une, ou une combinaison quelconque appropriée, des caractéristiques suivantes :
- la méthode comprend en outre le dépôt d'une pâte conductrice aux endroits du support, de la couche conductrice, ou de la couche isolante, si cette dernière est présente, la pâte conductrice étant destinés à recevoir le ou les composants électroniques et/ou au niveau des moyens d'alimentation en électricité, éventuellement suivi d'un traitement thermique de ladite pâte conductrice,
- l'étape de dépôt de la couche isolante, si cette dernière est présente, est réalisée avant l'étape de dépôt de la pâte conductrice et son traitement thermique,
- l'étape de dépôt de la couche isolante, si cette dernière est présente, est réalisée après une étape de traitement thermique de la pâte conductrice et avant une étape d'élimination de la couche isolante n'ayant pas adhérée à la pâte conductrice traitée thermiquement, suivie par la mise en contact électrique du ou des composants électroniques,
- l'étape de structuration d'une ou des deux pistes pour obtenir une valeur de résistance désirée s'accompagne d'une étape de mesure de résistance électrique des pistes conductrices,
- l'étape de réalisation des moyens d'alimentation en électricité comprend la réalisation de connecteurs par engagement de pièces conductrices dans des trous débouchant pratiqués dans le support,
- la méthode comprend outre une étape de dépôt, sur la couche conductrice ou la couche isolante si cette dernière est présente et/ou le ou les composants électroniques, d'au moins une couche supplémentaire ayant des propriétés hydrophobes et/ou oléophobes, hydrophiles et/ou oléophiles, photocatalytiques, antisalissures réfléchissant le rayonnement thermique ou infra rouge et/ou antireflets.

### Brève description des figures

La figure 1 est une représentation schématique d'une vue de profil d'un mode de réalisation du panneau selon l'invention.
La figure 2 est une représentation schématique d'une vue du dessus du mode de réalisation représenté à la figure 1.
La figure 3 est une représentation schématique d'une vue du dessus d'un second mode de réalisation du panneau selon l'invention.

### Description détaillée de l'invention

Le panneau 1 selon la présente invention comprend un support 2, comprenant une couche conductrice 3, un ou plusieurs composants électroniques 4, des moyens 5 d'alimentation du ou des composants électroniques 4 en électricité, et éventuellement, une couche isolante 6.

Le support 2 est sensiblement plan, et comprend au moins une première surface 7, de préférence une seconde surface 8, opposée à ladite première surface 7. De préférence, le support 2 est de forme parallélépipédique, mais en fonction de l'utilisation finale du panneau 1, il peut avoir toutes les formes adéquates.

Le support 2 est de préférence transparent, semi-transparent ou opaque, ou bien partiellement transparent, semi-transparent ou opaque. Il peut être sablé et/ou sérigraphie et/ou coloré.

De préférence, le support 2 est, ou comprend, du plastique, du verre, une matière cristalline ou semi-cristalline, une céramique ou une vitrocéramique.

Dans un mode de réalisation préféré de l'invention, le support 2 est une céramique, de préférence, à base d'oxyde d'yttrium Y₂O₃, ou une céramique tel que le grenat d'yttrium-aluminium dopé au néodyme.

Dans un mode de réalisation préféré de l'invention, le support 2 est du verre, de préférence, un verre sodocalcique transparent ou teinté dans la masse, éventuellement à couches diverses, telles que anti-bactériennes, anti-réfléchissantes, par exemple du type connu sous la marque Matelux^{®}, chromées, à faible émissivité, par exemple du type connu sous le nom de Planibel Clear ou de Planibel low-E IsoComfort, commercialisé par la société AGC, ou un borosilicate par exemple connu sous la marque Borofloat^{®} 33. De préférence, le verre est à forte teneur en SiO₂, une teneur avantageusement comprise entre 69% et 81% en poids et avec une transmission lumineuse pouvant aller jusqu'à 90%. Le verre peut avoir éventuellement préalablement subi un traitement thermique du type durcissement, recuit, trempe, bombage.

De préférence, le support 2 a des dimensions et une épaisseur adéquates, qui sont fonctions de l'utilisation finale du panneau 1 selon l'invention. Par exemple, le support 2 peut avoir des dimensions comprises entre 100x200 mm et 2000x1100 mm et une épaisseur comprise entre 3 et 10 mm.

Le support 2 comprenant sur une de ces surfaces 7 ou 8, de préférence sur ces deux surfaces 7 et 8, une couche conductrice 3 recouvrant de préférence la totalité de ladite ou lesdites surface 7 et/ou 8 du support 2.

Qu'elle soit sur une ou deux surfaces 7 et/ou 8 du support 2, la couche conductrice 3 peut recouvrir toute la surface 7, ou les surfaces 7 et 8, du support 2, éventuellement de préférence à l'exception de l'endroit ou des endroits sur le(s)quel(s) se positionne(nt) le ou les composants électroniques 4 et avantageusement également les moyens 5 d'alimentation du ou des composants électroniques 4 en électricité.

De préférence, la couche conductrice 3 supporte, sans modifications majeures de ces propriétés physiques, chimiques et électriques, un éventuel traitement thermique à des températures comprises entre 600 et 1000°C.

De préférence, la couche conductrice 3 comprend, ou est constituée, d'un ou plusieurs oxydes d'un ou plusieurs métaux ou alliages de métaux conducteurs. Avantageusement, la couche conductrice 3 comprend au moins de l'oxyde d'étain de formule SnO₂ ou de l'oxyde d'indium dopé à l'étain, du type In₂O₃ :Sn. Néanmoins, il peut également s'agir de FTO (SnO₂: F) ou ATO (SnO: Sb), ou oxyde de zinc dopé à l'aluminium (ZnO :Al) ou à l'indium (ZnO :In).

De préférence, la couche conductrice 3 comprend, ou est constituée, de SnO₂, qui présente l'avantage d'une forte conductivité électrique, d'une transmission optique élevée et d'une bonne résistance chimique.

Dans un autre mode de réalisation, la couche conductrice 3 peut être, ou comprendre, un polymère conducteur ou une colle, tel que le polymère commercialisé par la société Heraeus Clevios™ sous les noms SV4 et SV3, stabilisé ou non.

De préférence, la couche conductrice 3 a une épaisseur comprise entre 10 nm et 100 µm, de manière encore préférée entre 300 et 450 nm.

De préférence, la couche conductrice 3 a une résistance de surface variant entre 5 et 25 Ω/carré.

La couche conductrice 3 est structurée. C'est à dire que la couche conductrice 3 est discontinue sur le support 2, et comprend au moins une ligne de discontinuité 9 dans l'épaisseur de la couche conductrice 3, une ligne dépourvue de toute matière conductrice. La largeur de cette au moins une ligne de discontinuité 9 est de préférence la plus petite possible afin d'être peu ou pas visible à l'oeil nu. Avantageusement, cette ou ces lignes de discontinuité 9 ont une largeur comprise entre 1 nm et 5 mm.

La couche conductrice 3 structurée présente l'avantage de délimiter, sur le support 2, au moins deux pistes conductrices 10 et 11 distinctes, formant des conducteurs de tension entre des moyens d'alimentation électrique et un ou plusieurs composants électroniques 4, la première des deux pistes 10 ou 11 correspondant à un pôle électrique positif, la seconde piste 10 ou 11 correspondant à un pôle électrique négatif.

La taille des pistes conductrices 10 et 11, des conducteurs de tension, est choisie en fonction de l'alimentation utilisée, par exemple un courant continu, de très basse tension.

La couche conductrice 3 structurée, en au moins deux pistes conductrices 10 et 11, présente l'avantage de former des conducteurs de tension dont la ou les lignes de démarcation sont peu ou pas visibles à l'oeil nu, et de permettre une grande liberté de disposition du ou des composants électroniques 4 sur le panneau 1. Le ou les composants électroniques 4 et les moyens 5 d'alimentation en électricité, ou l'alimentation électrique, peuvent être regroupés, ou éparpillées, à différents endroits du support 2, et donc de les disposer éloignés les uns des autres, en particulier de disposer le ou les composants électroniques 4 éloignés des moyens 5 d'alimentation en électricité ou de l'alimentation électrique tout en utilisant un circuit électrique peu ou pas visible à l'oeil nu.

La couche conductrice 3 structurée présente en outre l'avantage de pouvoir introduire une résistance de régulation, qui peut être affinée en fonction de l'intensité de fonctionnement du ou des composants électroniques 4, en fonction de la résistance ohmique désirée, permettant ainsi la suppression de l'emploi de composants de résistances. Le panneau 1 selon l'invention ne comprend alors que le ou les composants électroniques 4 désirés ou d'utilité.

La résistance de régulation est obtenu par au moins une, de préférence une multitude de lignes de discontinuité 12 dans l'épaisseur d'une ou des au moins deux pistes conductrices 10 et 11. Les conducteurs de tension ainsi formés peuvent avoir une taille identique ou bien différente.

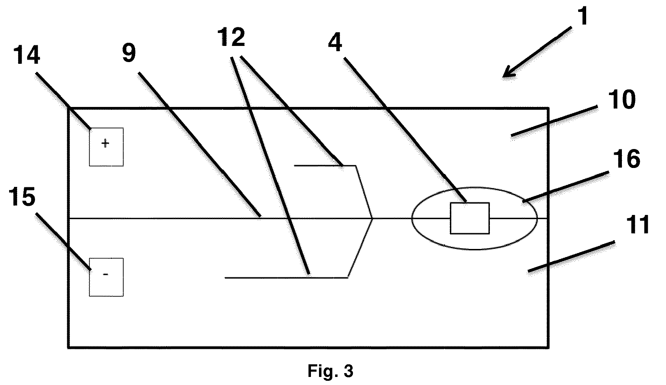

Par exemple, si la résistance désirée de la couche conductrice est de 75 ohms, la réalisation des au moins deux pistes conductrices 10 et 11 conduit à obtenir une résistance de 50 ohms, la structuration supplémentaire des deux pistes conductrices 10 et 11 (figure 3) permet d'atteindre la valeur désirée de 75 ohms.

La ou les au moins deux pistes conductrices 10 et 11, structurées par une ou des lignes de discontinuité 12, présentent également l'avantage de réduire l'intensité d'un éventuel court-circuit pouvant se produire, par exemple, lorsqu'un objet ou élément métallique ou un conducteur, comme de l'eau ou de l'humidité, vient en contact avec les au moins deux pistes conductrices 10 et 11 de tension. La couche conductrice réagit alors comme une résistance chauffante dont la puissance varie selon l'endroit du court-circuit.

Que les au moins deux pistes conductrices 10 et 11 soient structurées par une ou des lignes de discontinuité 12, ou pas, le panneau 1 selon l'invention peut comprendre en outre une couche isolante 6 recouvrant la couche conductrice 3 et éventuellement le support 2 au niveau des lignes de discontinuité 9 et 12. L'emploi de la couche isolante 6 présente l'avantage de permettre au panneau 1 selon l'invention de garantir le fonctionnement du ou des composants électroniques 4 qu'il comprend, même lorsque le panneau 1 reçoit sur sa surface un objet métallique ou un conducteur, comme par exemple de l'eau ou de l'humidité.

Le mode de réalisation dans lequel le panneau 1 comprend au moins deux pistes conductrices 10 et 11 structurées et une couche isolante 6 les recouvrant présente l'avantage d'obtenir un panneau 1 isolé de tout élément conducteur extérieur au panneau 1, protégé des courts-circuits qui pourraient résulter du contact avec objet métallique ou conducteur, et ayant une résistance de régulation, sans l'emploi de composants de résistances, de préférence une résistance de régulation ajustée, avantageusement ajustée finement, en fonction de l'intensité de fonctionnement du ou des composants électroniques 4 et/ou en fonction de la résistance ohmique désirée.

La couche conductrice 3 pouvant recouvrir une ou les deux surfaces 7 et 8 du support 2, la couche isolante 6 peut recouvrir la couche conductrice d'une, de préférence des deux surfaces 7 et 8, de préférence à l'exception du ou des composants électroniques 4 et de la colle ou pâte conductrice 13, et avantageusement également à l'exception des moyens 5 d'alimentation du ou des composants électroniques 4 en électricité.

De préférence, la ou les couches isolantes 6 sont transparentes ; néanmoins, elles peuvent être semi-transparentes, ou partiellement transparentes, semi-transparentes ou opaques, éventuellement également être sérigraphiées et/ou colorées.

De préférence, la ou les couches isolantes 6 comprennent, ou sont constituées, d'un ou plusieurs oxydes métallique non conducteur. Il peut s'agir de composés à base de titane tel que TiO₂, ou d'oxyde de silicium SiO₂, ou encore un composé de type Ca₂O₃. De préférence, il s'agit d'oxyde de silicium (SiO₂).

De préférence, la ou les couches isolantes 6 possèdent des propriétés mécaniques, chimiques ou thermiques d'intérêt. Ainsi, la ou les couches isolantes 6 peuvent avoir des propriétés hydrophobes et/ou oléophobes, hydrophiles et/ou oléophiles, photocatalytiques, antisalissures, anti-solaires, antireflets et/ou thermiquement isolantes.

De préférence, l'épaisseur de la ou les couches isolantes 6 est comprise entre 0.01 et 400 *µ*m, ce qui présente l'avantage d'avoir un panneau 1 ayant une épaisseur correspondante à celle d'un panneau en verre classiquement utilisé.

Le ou les composants électroniques 4 comprennent ou sont tous composants adéquats destinés à conférer au panneau 1 selon l'invention une fonctionnalité particulière et/ou dédiés à une ou plusieurs applications. Il s'agit de Composants Montés en Surface (CMS). Il peut s'agir par exemple de condensateurs, de diodes, de circuits intégrés et/ou de résistances.

Dans un mode de réalisation particulier, le ou les composants électroniques 4 comprennent ou sont une ou plusieurs diodes électroluminescentes. De préférence, il s'agit de des diodes électroluminescentes à diffusion perpendiculaire ou angulaire de couleur fixe ou variable.

Le ou les composants électroniques 4 sont disposés directement sur le support 2, ou directement sur la couche conductrice 3, ou bien sur une pâte conductrice 13, cette dernière pouvant être déposée sur la couche conductrice 3 ou sur la couche isolante 6, de préférence une pâte conductrice 13 ayant préalablement subi un traitement thermique ou vitrification. Le ou les composants électroniques sont en contact électrique avec au moins les deux pistes conductrices 10 et 11 de la couche conductrice 3 formant les conducteurs de tension, un des plots conducteurs du ou des composants électroniques 4 étant mis en contact électrique avec une des deux pistes 10 ou 11 et l'autre plots conducteurs étant mis en contact électrique avec l'autre des deux pistes 10 ou 11. La couche conductrice 3 pouvant être divisée en une multitude de pistes conductrices 10 et 11, ou conducteurs de tension, les composants électroniques 4 pouvant alors être connectés en série. Des dispositions mixtes, série et parallèle, peuvent aussi être prévues.

Le ou les composants électroniques 4 sont fixés au support 2, ou à la couche conductrice 3, et en contact électrique avec la couche conductrice 3 par tous moyens adéquats, de préférence par l'emploi d'une colle conductrice ou bien d'une pâte conductrice 13, de préférence traitée thermiquement ou vitrifiée. L'emploi d'une colle conductrice présente l'avantage de permettre la soudure et la mise en contact électrique, alors que l'emploi d'une pâte conductrice 13 présente l'avantage d'avoir une meilleure mise en contact électrique. Avantageusement, l'emploi de la pâte conductrice 13 se fait avec un apport d'un composant de soudure, par exemple de l'étain, ce qui améliore la qualité de la soudure.

De préférence, la colle est du type mono-composant à base d'acrylate, avantageusement durcissable par son exposition à un rayonnement UV et/ou UVA lumière visible, telle que, par exemple, la colle connue sous la marque Delo-Photobond^{®} AD414 et commercialisée par la société DELO, ou une colle à base de résine époxy, de préférence comprenant des charges métalliques, avantageusement de l'Argent, comme par exemple la colle commercialisée sous le nom Elecolit^{®} 3012.

De préférence, la pâte conductrice 13 est à base d'argent, avec plus de 50% en poids de solide. Avantageusement, elle comprend également du terpinéol anhydre. A titre d'exemple, il peut s'agit de la pâte connue sous la dénomination S2028 F de la société Metalor^{®}, comprenant en outre de la colophane et du cyclohexanol. La pâte conductrice 13 peut comprendre 50 à 100% en poids d'argent, de 10 à 20% en poids de terpinéol anhydre, de 2,5 à 10% en poids de formaldéhyde, de 2,5 à 10 de bore, et moins de 2,5% en poids de sulfate de cuivre pentahydrate. Avantageusement, il s'agit de la pâte d'argent sans plomb connue sous la dénomination A-6474AP de la société Metalor^{®}. A titre subsidiaire, la pâte conductrice 13 peut également être la pâte connue sous la dénomination LPA 410-117 de la société Heraeus.

Les moyens 5 d'alimentation du ou des composants électroniques 4 en électricité comprennent tous moyens permettant de lier électriquement le ou les composants électroniques 4 à une source d'électricité, de préférence basse tension, une source qui de préférence ne fait pas partie du panneau 1 selon l'invention.

Les moyens 5 d'alimentation peuvent, par exemple, comprendre des fils conducteurs.

Dans un mode de réalisation particulier, ces moyens 5 comprennent au moins deux connecteurs 14 et 15, dont l'un est en contact électrique avec l'une des pistes conductrices 10 ou 11 de la couche conductrice 3 et l'autre est en contact électrique avec l'autre des pistes conductrices 10 ou 11.

De préférence, les connecteurs 14 et 15 des moyens 5 d'alimentation sont disposés sur le support 2, à l'extrémité opposée de celle où se trouve le ou les composants électroniques 4.

De préférence, les connecteurs 14 et 15 des moyens 5 d'alimentation permettent d'alimenter en électricité, de façon concomitante, les deux surfaces 7 et 8 du support 2. Dans un mode de réalisation particulier, les connecteurs 14 et 15 comprennent, ou sont constitués, chacun par une pièce conductrice, de préférence une pièce métallique, s'engageant dans, et s'étendant au delà, d'un trou débouchant pratiqué dans le support 2 et soudée, au support 2 ou à la couche conductrice 3, par une pâte conductrice 13, de préférence une pâte à base d'argent avec plus de 50% de solide. Ce mode de réalisation présente l'avantage de permettre d'alimenter en électricité les deux surfaces 7 et 8 d'un même support 2.

Le panneau 1 selon l'invention peut comprendre en outre une ou plusieurs couches supplémentaires lui conférant des propriétés particulières, en plus de celle(s) conférée(s) par le ou les composants électroniques 4. Cette ou ces couches supplémentaires peuvent recouvrir tout ou partie du panneau 1, et peuvent recouvrir en particulier le ou les composants électroniques 4.

A titre d'exemple, le panneau 1 peut comprendre une couche d'un matériau hydrophobe et/ou oléophobe, hydrophile et/ou oléophile, photocatalytique, antisalissure, réfléchissant le rayonnement thermique ou infra rouge (bas-émissif) et/ou anti reflet.

Dans un mode de réalisation particulier du panneau 1 selon l'invention, indépendamment de la présence d'une couche supplémentaire telle que décrite précédemment, le ou les composants électroniques 4 peuvent être recouverts d'un revêtement étanche 16, comprenant ou constitué d'une résine, ou d'une colle, transparente. La résine permet d'enrober et d'encapsuler le ou les composants électroniques 4 de manière à assurer une protection contre l'humidité, ainsi que les contraintes thermiques et extérieures. La colle, quant à elle, permet d'assurer à la fois l'assemblage du ou des composants électroniques 4 et sa protection contre l'environnement extérieur. En fonction du choix du revêtement étanche 16, le procédé d'application pourra être différent.

De préférence, la colle utilisée comme revêtement étanche 16 est une colle UV acrylate mono-composant. De préférence, elle comprend de 25 à 100% en poids de 2-acetoxyethylmethacrylate, de 10 à 25% en poids d'isobornyl acrylate, de 10 à 25% en poids de polytétramethyler-éthylène-glycol-dimethacrylate, de 10 à 25% en poids d'acide méthacrylique, moins de 3% en poids de béta-carboxyléthylacrylate, plus de 2,5% en poids d'oligomères d'acide acrylique et moins de 1% en poids d'acide acrylique. Avantageusement, il s'agit de la colle connue sous la marque Delo-Photobond^{®} 4302 de la société DELO. Toutefois, il peut également s'agir de la colle connue sous la marque Delo-Photobond^{®} GB368. La colle peut également être à base résine epoxy mono-composant telle que par exemple la résine connu sous la marque Delo-Katiobond^{®} OB642.

De préférence, l'épaisseur du panneau 1 selon l'invention, à savoir l'épaisseur du support 2 et de la couche conductrice 3 et éventuellement également la couche isolante 6, est comprise entre 3 et 12 mm.

Le panneau 1 selon l'invention peut être utilisé dans le domaine de l'aménagement intérieur ou extérieur, comme cloisons ou marches d'escaliers par exemple, comme vitrage d'aquarium, dans le domaine des appareils électroménagers, comme portes de cuisinières, de fours ou de réfrigérateurs, ou tablettes de réfrigérateur, ou bien encore dans le domaine de l'ameublement, comme tablette de meubles, d'armoires, de commodes ou de vitrines, dans le domaine des équipements sanitaires, comme éléments de douche, dans le domaine de l'automobile, par exemple comme vitrages ou toits panoramiques.

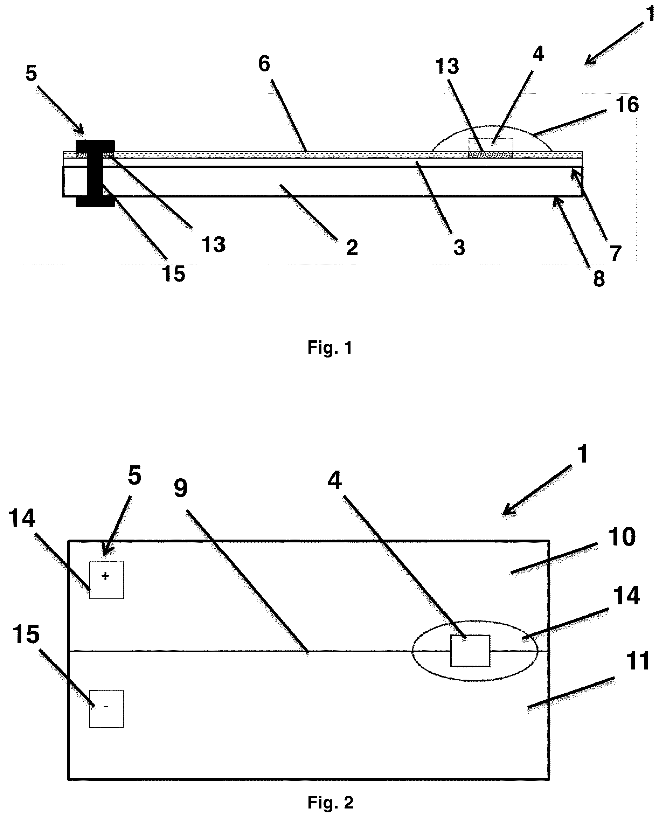

Le panneau selon l'invention est décrit maintenant pour un mode de réalisation particulier de l'invention représenté aux figures 1 à 3, dans lequel le panneau 1 selon l'invention est un panneau lumineux. Le support 2, fait de verre transparent, est de forme parallélépipédique, de 478 mm de long et de 359 mm de large et d'une épaisseur comprise entre 3 et 5 mm, Le support 2 est recouvert, sur l'une de ces surfaces, d'une couche conductrice 3 transparente, à base d'oxyde d'étain (SnO₂), d'une épaisseur entre 350 et 400 nm, divisée, en deux pistes conductrices 10 et 11 distinctes, par une ligne de discontinuité 9, un sillon, d'une profondeur égale à l'épaisseur de la couche conductrice 3, ne comprenant pas de matériaux conducteur, et d'une largeur de 1 mm. Les deux pistes conductrices 10 et 11 peuvent être structurées par des ligne de discontinuités 12 supplémentaire afin d'atteindre une résistance de 90 ohms. A l'une des extrémités de panneau 1 est fixée, sur la couche conductrice 3, une diode électroluminescente par l'intermédiaire d'une pâte conductrice 13 à base d'argent, avec environ 82% en poids de solide. A l'autre extrémité du panneau 1, de part et d'autre du sillon 9 séparant les pistes conductrices 10 et 11, le support 2 est percé de deux trous débouchant recevant des pièces métalliques formant les connecteurs 14 et 15, les pièces métalliques et les pistes conductrices 10 et 11 respectives étant mis en contact électrique par l'intermédiaire d'une pâte 13 à base d'argent. La couche conductrice 3 et le support 2 au travers des lignes de discontinuité 9 et 12 sont recouverts d'une couche isolante 6 transparente d'oxyde de silicium, à l'exception des connecteurs 14 et 15 et de la diode électroluminescente. Cette dernière est recouverte d'une colle UV acrylate mono-composant.

Ce mode de réalisation particulier de l'invention, avec éventuellement une couche transparente hydrophobe et/ou oléophobe, hydrophile et/ou oléophile, photocatalytique, antisalissure, réfléchissant le rayonnement thermique ou infra rouge (bas-émissif) et/ou antireflet, présente l'avantage de permettre à la lumière de la LED de diffuser dans, et au travers, du panneau 1 améliorant ainsi l'éclairage du ou des objets présents sur le panneau 1.

La présente invention a également pour objet un procédé de réalisation d'un panneau 1 selon l'invention.

Le procédé comprend la fourniture d'un support 2, tel que décrit précédemment, puis l'application d'une couche conductrice 3, telle que décrite précédemment, sur tout ou partie d'une ou des deux surfaces du support 2, de préférence sur la totalité du support 2. Cette application peut être faite par toute méthode adéquate, par exemple par pyrolyse, voie poudre ou gazeuse, par pulvérisation cathodique par magnétron, par évaporation, sérigraphie ou jet d'encre. Alternativement, le procédé selon l'invention peut prévoir de fournir un support 2 comprenant déjà une couche conductrice 3, et comprenant éventuellement déjà également des moyens 5 d'alimentation du ou des composants électroniques 4 en électricité, en particulier deux trous débouchant et/ou un ou plusieurs composants électroniques 4, déposés sur le support 2 ou sur la couche conductrice 3.

De préférence, le procédé selon l'invention prévoit une étape de dépôt d'une pâte conductrice 13 à l'endroit ou aux endroits destinés à recevoir le ou les composants électroniques 4 et/ou au niveau des moyens 5 d'alimentation du ou des composants électroniques 4 en électricité, en particulier autour des trous débouchant du support 2. La dépose peut se faire par toute méthode adéquate, de préférence par sérigraphie, par voie liquide ou dépôt sous vide. La pâte conductrice 13 peut être déposée directement sur le support 2, de préférence elle est déposée sur la couche conductrice 3, mais elle peut également l'être sur la couche isolante 6.

De préférence, la pâte conductrice 13 subie ensuite un traitement thermique, par exemple une trempe thermique, permettant ainsi d'améliorer sa soudabilité au support 2 ou à la couche conductrice 3.

De préférence, le traitement thermique consiste en une vitrification lors d'une trempe thermique entre 650°C et 750°C, pendant une période comprise entre 1 et 10 minutes, de préférence entre 2 et 5 minutes. Lors de ce traitement, une pellicule se forme sur la surface de la pâte conductrice 13 vitrifiée, probablement due à un phénomène d'oxydation de ladite pâte conductrice 13. Si l'emploi d'un composant de soudure, par exemple d'étain, est envisagé, la pâte conductrice 13 peut être à nouveau soumise à un traitement thermique allant jusqu'à 300°C par exemple au moyen d'une lampe infrarouge ou par un chauffage à l'aide d'air chaud.

La couche conductrice 3 est structurée, ou découpée, afin de délimiter au moins deux pistes conductrices 10 et 11 distinctes, pour former les conducteurs de tension. Cette étape comprend la suppression de la matière conductrice de la couche conductrice 3 du support 2 entre l'endroit destiné à recevoir le ou les composants électroniques 4 et les moyens 5 d'alimentation en électricité. Cette suppression peut être mécanique ou chimique.

De préférence, une ablation par LASER est utilisée, ce qui présente l'avantage d'obtenir une structuration de la couche conductrice 3 peu visible à l'oeil nu, avec un minimum d'altération du support 2.

Le procédé selon l'invention peut comprendre en outre une étape supplémentaire de structuration, ou de découpe, des au moins deux pistes conductrices 10 et 11, afin de réduire leur taille et obtenir ainsi une valeur de résistance électrique désirée, qui est choisie notamment en fonction du ou des composants électroniques 4 du panneau 1. De préférence, cette étape supplémentaire peut s'accompagner de mesures de résistance électrique des pistes conductrices 10 et 11, réalisées simultanément, ou quasi simultanément, durant la structuration supplémentaire, des mesures qui sont réalisées, de préférence, en temps réel. Cette étape de mesure de résistance électrique des pistes conductrices 10 et 11 présente l'avantage de pouvoir aux au moins deux pistes 10 et 11, de préférence à la multitude de pistes conductrices, de la couche conductrice 3, la résistance voulue, d'approcher la valeur de résistance électrique théorique du ou des composants électroniques 4, tout en tenant compte du matériau utilisé comme support 2 et de sa résistance électique intrinsèque.

De préférence, les étapes de formation des au moins deux pistes conductrices 10 et 11 et de la structuration supplémentaire des au moins deux pistes conductrices 10 et 11 si elle se fait, s'effectuent de préférence après le traitement thermique de la pâte conductrice 13, et ce, afin de réduire les variations de résistance des pistes conductrices 10 et 11 qui auraient pu avoir lieu lors du traitement thermique de la pâte conductrice 13.

Le procédé comprend également une étape de pose et de fixation du ou des composants électroniques 4, soit sur la couche conductrice 3, par soudure directe ou apport d'un composant de soudure, par exemple d'étain, soit sur la pâte conductrice 13. Les plots conducteurs du ou des composants électroniques 4 sont mis en contact électrique avec respectivement les au moins deux pistes conductrices 10 et 11 de la couche conductrice 3.

De préférence, pour améliorer la soudure du ou des composants électroniques 4, le composant de soudure est une pâte à braser ou pâte à souder, cette dernière étant, de préférence, préalablement chauffée à une température comprise entre 100 et 300 °C avant d'être mise en contact avec les plots conducteurs du ou des composants électroniques 4.

Le procédé selon l'invention comprend en outre une étape de réalisation des connecteurs 14 et 15, en particulier de pose et de fixation de pièces conductrices dans les trous débouchant du support 2, de préférence par l'intermédiaire de la pâte conductrice 13.

L'étape de dépôt de la couche isolante 6 peut être réalisée avant ou après le dépôt de la pâte conductrice 13, dans le mode de réalisation qui en comprend.

Dans le mode de réalisation dans lequel le dépôt se fait avant celui de la pâte conductrice 13, le traitement thermique, ou vitrification, de cette dernière lui permet de pénétrer au travers de la couche isolante 6 afin de pouvoir réaliser un contact électrique avec la couche conductrice 3.

Dans le mode de réalisation dans lequel le dépôt se fait avant celui de la pâte conductrice 13, il peut se faire à l'aide d'un masque pour que la couche isolante 6 entoure la pâte conductrice 13 sans toutefois la recouvrir. De façon alternative, le dépôt de la couche isolante 6 peut se faire également sur la pâte conductrice 13, qui aura été préalablement traitée thermiquement, et dont la surface aura été éventuellement décapée, par frottement ou grattage afin de la rendre non-adhérente à la couche isolante 6, cette dernière étant ensuite éliminée au niveau de la pâte conductrice 13 par tous moyens adéquats, par exemple par décapage, frottement ou grattage. Ainsi, la couche isolante 6 n'est supprimée qu'au niveau de la pâte de soudure 13 et donc également au niveau des connecteurs du ou des composants électroniques 4 ou des connecteurs 14 et 15 des moyens 5 d'alimentation en électricité.

Ainsi, la couche isolante 6 est déposée avec une grande précision sur le tour de toute la surface de pâte conductrice 13, quelle que soit sa forme.

De préférence, la ou les couches isolantes 6 sont déposées par pulvérisation cathodique.

La méthode selon l'invention comprend en outre la mise en contact électrique du ou des composants électroniques 4 avec la couche conductrice 3, de préférence, la fixation des plots de connexion dudit ou desdits composants électroniques 4 sur la pâte conductrice 13 vitrifiée et dépourvue de couche isolante 6.

La méthode selon l'invention comprend éventuellement également le dépôt d'un revêtement étanche 16 sur le ou les composants électroniques 4, de préférence une résine ou une colle, telle que décrite précédemment.

La méthode selon l'invention comprend en outre la réalisation des moyens 5 d'alimentation, en particulier des connecteurs 14 et 15.

En particulier, pour le mode de réalisation dans lequel les deux surfaces 7 et 8 du support 2 comprennent une couche conductrice 3, la méthode selon l'invention comprend l'engagement d'une pièce conductrice, de préférence une pièce étallique, dans des trous débouchant pratiqués dans le support 2 et soudée, au support 2 ou à la couche conductrice 3, par une pâte conductrice 13, de préférence une pâte à base d'argent.

La méthode selon l'invention peut comprendre en outre une ou plusieurs étapes de dépôt d'une ou plusieurs couches supplémentaires conférant des propriétés particulières au panneau 1 selon l'invention, en plus de celle(s) conférée(s) par le ou les composants électroniques 4. Il peut s'agir par exemple de propriétés hydrophobes et/ou oléophobes, hydrophiles et/ou oléophiles, photocatalytiques, antisalissures, réfléchissant le rayonnement thermique ou infra rouge et/ou antireflets.

## Revendications

1. Panneau (1) comprenant un support (2) comprenant au moins une surface (7 ou 8) recouverte d'une couche conductrice (3), structurée pour délimiter au moins deux pistes (10, 11) formant des conducteurs de tension en contact électrique avec un ou plusieurs composants électroniques (4) et des moyens (5) d'alimentation en électricité dudit ou desdits composants électroniques (4) **caractérisé en ce que** ledit panneau (1) comprend des moyens d'isolation électrique comprenant une ou plusieurs lignes de discontinuité (12) dans l'épaisseur d'une ou plusieurs desdites au moins deux pistes conductrices (10 et 11) et/ou une couche isolante (6) recouvrant ledit support (2) et ladite couche conductrice (3).

2. Le panneau (1) selon la revendication 1, dans lequel les au moins deux pistes (10, 11) sont en contact électrique avec un ou plusieurs composants électroniques (4) et des moyens (5) d'alimentation en électricité par l'intermédiaire d'une pâte conductrice (13).

3. Le panneau (1) selon la revendication 2, dans lequel la pâte conductrice (13) est appliquée sur la couche conductrice (3) ou sur la couche isolante (6) si cette dernière est présente.

4. Le panneau (1) selon l'une quelconque des revendications précédentes, dans lequel la couche isolante (6) ne recouvre pas le ou les composants électroniques (4), ni la pâte conductrice (13) si cette dernière est présente.

5. Le panneau (1) selon l'une quelconque des revendications précédentes, dans lequel le support (2) est fait de verre transparent, la couche conductrice (3) est transparente et comprend de l'oxyde d'étain, la couche isolante (6) est transparente est comprend un ou plusieurs oxydes métalliques non conducteurs et le ou les composants électroniques (4) sont des Diodes Electro Luminescentes.

6. Le panneau (1) selon l'une quelconque des revendications précédentes, dans lequel les moyens (5) d'alimentation en électricité du ou des composants électroniques (4) comprennent des connecteurs (14 et 15) comprenant chacun une pièce conductrice s'engageant dans, et s'étendant au-delà, d'un trou débouchant pratiqué dans le support (2).

7. Le panneau (1) selon l'une quelconque des revendications précédentes, comprenant en outre au moins une couche supplémentaire déposée sur la couche conductrice (3) ou la couche isolante (6) et/ou le ou les composants électroniques (4), ladite au moins une couche supplémentaire ayant des propriétés hydrophobes et/ou oléophobes, hydrophiles et/ou oléophiles, photocatalytiques, antisalissures réfléchissant le rayonnement thermique ou infra rouge et/ou antireflets.

8. Le panneau (1) selon l'une quelconque des revendications précédentes, étant une tablette de meubles, d'armoires, de commodes, de vitrines ou de réfrigérateurs, ou un vitrage d'automobile.

9. Méthode de fabrication d'un panneau (1) comprenant un ou plusieurs composants électroniques (4) et des moyens (5) d'alimentation en électricité dudit ou desdits composants électroniques (4), ladite méthode comprenant les étapes suivantes :
- prendre un support (2) comprenant au moins une surface (7 ou 8) et la recouvrir d'une couche conductrice (3), ou prendre un support (2) déjà recouvert d'une couche conductrice (3) sur au moins une surface (7 ou 8), et comprenant éventuellement des moyens (5) d'alimentation en électricité dudit ou desdits composants électroniques (4),
- réaliser sur ledit support (2) des moyens (5) d'alimentation en électricité si ledit support (2) n'en comprend pas déjà,
- structurer ladite couche conductrice (3) pour former au moins deux pistes (10, 11) formant des conducteurs de tension,
- mettre en contact électrique un ou des composants électroniques (4) avec ladite couche conductrice (3), de manière à être en contact électrique avec lesdites au moins deux pistes (10, 11),
- réaliser des moyens d'isolation dudit panneau (1), en réalisant une ou plusieurs lignes de discontinuité (12) dans l'épaisseur d'une ou plusieurs des au moins deux pistes conductrices (10, 11) et/ou en déposant une couche isolante (6) sur la couche conductrice (3) et le support (2).

10. La méthode selon la revendication 9, comprenant le dépôt d'une pâte conductrice (13) aux endroits du support (2), de la couche conductrice (3), ou de la couche isolante (6) si cette dernière est présente, ladite pâte conductrice (13) étant destinés à recevoir le ou les composants électroniques (4) et/ou au niveau des moyens (5) d'alimentation en électricité, éventuellement suivi d'un traitement thermique de ladite pâte conductrice (13).

11. La méthode selon la revendication 10, dans laquelle l'étape de dépôt de la couche isolante (6), si cette dernière est présente, est réalisée avant l'étape de dépôt de la pâte conductrice (13) et le traitement thermique de ladite pâte conductrice (13).

12. La méthode selon la revendication 10, dans laquelle l'étape de dépôt de la couche isolante (6), si cette dernière est présente, est réalisée après une étape de traitement thermique de la pâte conductrice (13) et avant une étape d'élimination de ladite couche isolante (6) n'ayant pas adhérée à ladite pâte conductrice (13) traitée thermiquement, suivie par la mise en contact électrique du ou des composants électroniques (4).

13. La méthode selon l'une quelconque des revendications 9 à 12, dans laquelle l'étape de structuration d'une ou des deux pistes (10, 11) pour obtenir une valeur de résistance désirée s'accompagne d'une étape de mesure de résistance électrique des pistes conductrices (10 et 11).

14. La méthode selon l'une quelconque des revendications 9 à 13, dans laquelle l'étape de réalisation des moyens (5) d'alimentation en électricité comprend la réalisation de connecteurs (14 et 15) par engagement de pièces conductrices dans des trous débouchant pratiqués dans le support (2).

15. La méthode selon l'une quelconque des revendications 9 à 14, comprenant en outre une étape de dépôt, sur la couche conductrice (3) ou la couche isolante (6) si cette dernière est présente et/ou le ou les composants électroniques (4), d'au moins une couche supplémentaire ayant des propriétés hydrophobes et/ou oléophobes, hydrophiles et/ou oléophiles, photocatalytiques, antisalissures réfléchissant le rayonnement thermique ou infra rouge et/ou antireflets.
